(19) Europäisches Patentamt
European Patent Office
Office européen des brevets

(11) **EP 1 332 521 B1**

(12) # EUROPÄISCHE PATENTSCHRIFT

(45) Veröffentlichungstag und Bekanntmachung des Hinweises auf die Patenterteilung:
**28.08.2013   Patentblatt 2013/35**

(51) Int Cl.:
**H01L 33/00** (2010.01)

(86) Internationale Anmeldenummer:
**PCT/DE2001/004171**

(21) Anmeldenummer: **01993029.6**

(22) Anmeldetag: **06.11.2001**

(87) Internationale Veröffentlichungsnummer:
**WO 2002/037578 (10.05.2002 Gazette 2002/19)**

(54) **STRAHLUNGSEMITTIERENDER CHIP**

RADIATION-EMITTING CHIP

PUCE EMETTRICE DE RAYONNEMENT

(84) Benannte Vertragsstaaten:
**DE FR GB**

(30) Priorität: **06.11.2000   DE 10054966**

(43) Veröffentlichungstag der Anmeldung:
**06.08.2003   Patentblatt 2003/32**

(73) Patentinhaber: **OSRAM Opto Semiconductors GmbH
93055 Regensburg (DE)**

(72) Erfinder:
 • **BAUR, Johannes
   93051 Regensburg (DE)**
 • **EISERT, Dominik
   93049 Regensburg (DE)**
 • **FEHRER, Michael
   93077 Bad Abbach (DE)**
 • **HAHN, Berthold
   93155 Hemau (DE)**
 • **HÄRLE, Volker
   93164 Waldetzenberg (DE)**

 • **JACOB, Ulrich
   93053 Regensburg (DE)**
 • **OBERSCHMID, Raimund
   93161 Sinzing (DE)**
 • **PLASS, Werner
   93047 Regensburg (DE)**
 • **STRAUSS, Uwe
   93077 Bad Abbach (DE)**
 • **VÖLKL, Johannes
   91056 Erlangen (DE)**
 • **ZEHNDER, Ulrich
   93049 Regensburg (DE)**

(74) Vertreter: **Epping - Hermann - Fischer
Patentanwaltsgesellschaft mbH
Ridlerstrasse 55
80339 München (DE)**

(56) Entgegenhaltungen:
 **EP-A- 0 415 640     EP-A- 0 562 880
 US-A- 5 429 954     US-A- 6 025 251**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft einen strahlungsemittierenden Chip mit einem Photonen emittierenden aktiven Bereich und einem diesen zugeordneten, insbesondere an diesen angrenzenden Auskoppelfenster, der eine Auskoppelfläche aufweist, über die zumindest ein Teil der von dem aktiven Bereich emittierten Strahlung aus dem Chip ausgekoppelt wird.

Aus der US 50 87 949 A ist ein Leuchtdiodenchip bekannt, der ein pyramidenstumpfförmiges n-dotiertes Auskoppelfenster aufweist. Entlang der Grundfläche des n-leitenden Grundkörpers ist eine p-leitende Schicht ausgebildet. Unterhalb der p-leitenden Schicht befindet sich eine Isolierschicht, die von einem zentralen Fenster unterbrochen ist. In dem Fenster ist die p-leitende Schicht von einer Kontaktschicht kontaktiert. Auf der Oberseite des pyramidenstumpfförmigen Grundkörpers befindet sich eine weitere Kontaktschicht. Durch die Isolierschicht ist der Stromfluß durch die p-leitende Schicht und den n-leitenden Grundkörper auf den Bereich des Fensters eingeschränkt. Bei Stromfluß werden im Bereich des Fensters entlang der Grenzfläche zwischen der p-leitenden Schicht und dem n-leitenden Grundkörper Photonen emittiert. Aufgrund der pyramidenstumpfförmigen Ausgestaltung des Grundkörpers trifft ein Großteil der Photonen auf eine Auskoppelfläche des pyramidenstumpfförmigen Grundkörpers unter einem Winkel, der kleiner als der kritische Winkel für die Totalreflexion ist. Dadurch weist dieses bekannte Bauelement eine vergleichsweise hohe Lichtausbeute auf.

Ein Nachteil des bekannten Leuchdiodenchips besteht darin, daß sich der pn-Übergang an der Montageseite des Chips befindet. Bei einer Montage mit elektrisch leitfähigem Silber-Epoxy-Kleber besteht daher eine hohe Gefahr, dass seitlich hochquellender Kleber den aktiven Bereich elektrisch kurzschließt, was zum Ausfall des Bauelements führt.

Aus der Druckschrift EP 0 562 880 A1 ist ein im Infraroten emittierendes Bauelement mit Galliumarsenidschichten bekannt, bei dem Seitenflächen eines Substrats zu einer Spaltfläche geneigt sind.

In der Druckschrift US 6,025,251 ist eine Halbleiterkomponente beschrieben, bei der eine Seitenfläche eines Halbleiterkörpers an die Rückseite angrenzend konvex und an die Vorderseite angrenzend konkav ausgebildet ist.

Die Druckschrift EP 0 415 640 A2 betrifft ein Lampe, bei der ein LED-Kubus in einer tassenförmigen reflektiven Öffnung angeordnet ist. Die Öffnung ist mit einem transparenten Material befüllt, welches eine halbkugelförmige Oberfläche bildet.

Ausgehend von diesem Stand der Technik liegt der Erfindung die Aufgabe zugrunde, einen verbesserten Chip der eingangs genannten Art zu schaffen, bei dem insbesondere die Gefahr eines Kurzschlusses des oder eines Teils des aktiven Bereichs weitestgehend beseitigt ist und bei dem die Lichtauskopplung verbessert ist.

Diese Aufgabe wird durch einen Chip mit den Merkmalen des Patentanspruches 1 gelöst.

Vorteilhafte Weiterbildungen der Erfindung sind in den abhängigen Ansprüchen angegeben.

Im Weiteren Text ist unter "Chipachse" eine senkrecht zu einer Montagefläche des Chips durch den Chip verlaufende Gerade zu verstehen.

Gemäß der Erfindung weist der aktive Bereich des Chips eine senkrecht zur Chipachse liegende Querschnittsfläche auf, die kleiner ist als eine senkrecht zur Chipachse liegende Querschnittsfläche des Auskoppelfensters und ist der aktive Bereich in Abstrahlungsrichtung des Chips dem Auskoppelfenster nachgeordnet. An der vom aktiven Bereich abgewandten und damit der Montagefläche zugewandten Seite des Auskoppelfensters ist eine Spiegelfläche ausgebildet. Diese Spiegelfläche ist größer als die oben genannte Querschnittsfläche des aktiven Bereichs und ist aus einer Metallisierungsschicht gebildet, die bevorzugt gleichzeitig zur elektrischen Kontaktierung des Chips verwendet wird.

Bei dem Chip gemäß der Erfindung ist der Photonen emittierende aktive Bereich weit genug entfernt von jeglichem elektrisch leitenden Verbindungsmittel zur Befestigung des Chips auf einem Chipträger, so dass die Gefahr eines elektrischen Kurzschlusses des aktiven Bereichs durch das elektrisch leitende Verbindungsmittel weitestgehend beseitigt ist. Der Chip gemäß der Erfindung läßt sich daher zuverlässig montieren.

In einer bevorzugten Ausführungsform des Bauelements gemäß der Erfindung weist eine zur Abstrahlrichtung des Chips gewandte Fläche eines seitlich über den aktiven Bereich hinausragenden Teilbereiches des Auskoppelfenster eine gekrümmte, beispielsweise eine kreisrund nach außen gewölbte Oberfläche auf. Bevorzugt ist die gekrümmte Oberfläche vollständig um den aktiven Bereich umlaufend, so dass das Auskoppelfenster zumindest eine einer kugelkalottenartigen Form angenäherte äußere Kontur aufweist.

Der Querschnitt des aktiven Bereichs und der Krümmungsradius $R_2$ der gekrümmten Oberfläche des Auskoppelfensters sind dabei so gewählt, daß der durch die Spiegelung an der Spiegelfläche entstehende virtuelle aktive Bereich innerhalb der dem Kreissegment zugeordneten Weierstrass'schen Kugel zu liegen kommt. Das bedeutet insbesondere, daß die Krümmungsradien $R_2$ größer als oder gleich der zweifachen Höhe des Bauelements sind. Außerdem ist die halbe maximale Außenabmessung $R_1$ des aktiven Bereichs entlang der Auskoppelfläche $R_1 < R_2 \, n_A/n_i$, wobei $n_i$ der Brechungsindex des Materials des Auskoppelfensters und $n_A$ der Brechungsindex der Umgebung ist, die insbesondere von einem Chip-Verguss gebildet ist.

Mit dieser Anordnung kommt der Chip der Idealform nach Weierstrass nahe, da der virtuelle aktive Bereich innerhalb der Weierstrass'schen Kugel liegt und die dort virtuell erzeugten Photonen den Grundkörper verlassen können.

Bei Erfindung eignet sich besonders bevorzugt für Chips, bei den das Material des Auskoppelfensters einen größeren Brechungsindex aufweist als das an diese angrenzende Material des aktiven Bereichs, der meist als aktive Mehrschichtstruktur ausgebildet ist. Dadurch wird vorteilhafterweise die Reflexion der von der aktiven Zone nach hinten ausgesandten Strahlung an der Grenzfläche zwischen aktivem Bereich und Auskoppelfenster vermindert und es erfolgt eine Komprimierung der in das Auskoppelfenster eingekoppelten Strahlung.

Die erfindungsgemäße Chipgeometrie wird besonders bevorzugt bei Nitrid-basierten LED-Chips verwendet, bei dem die aktive Mehrschichtstruktur auf einem SiC- oder SiC-basierten Aufwachs-Substrat hergestellt ist. Hier gilt Brechungsindex$_{aktive}$ Schicht > Brechungsindex$_{substrat}$. GaN-basierte LED-Chips sind LED-Chips, deren strahlungsemittierende Schicht beispielsweise GaN, InGaN, AlGaN und/oder InGaAlN aufweist.

Unter "Nitrid-basiert" fallen insbesondere alle binären, ternären und quaternären Stickstoff aufweisenden III-V-Halbleiter-Mischkristalle, wie GaN, InN, AlN, AlGaN, InGaN, InAlN und AlInGaN.

Analog dazu ist mit "SiC-basiert" jedes Mischkristall gemeint, dessen wesentliche Eigenschaften von den Bestandteilen Si und C geprägt ist.

Die Schichtenfolge des aktiven Bereichs wird vorzugsweise bereits auf ein Substratmaterial aufgewachsen, das später zu Auskoppelfenstern weiterverarbeitet wird.

Nachfolgend wird ein erfindungsgemäßes Ausführungsbeispiel, sowie weitere, nicht erfindungsgemäße Ausführungsbeispiele im einzelnen anhand der beigefügten Zeichnungen erläutert. Es zeigen:

Figur 1     eine schematische Darstellung eines Querschnitts durch ein dem Weierstrass-Prinzip folgenden Licht erzeugenden Element;

Figur 2     eine schematische Darstellung eines Querschnitts durch einen Chip;

Figur 3     eine schematische Darstellung eines Querschnitts durch den Chip aus Figur 2, bei der die Lage des virtuellen aktiven Bereichs eingezeichnet ist;

Figur 4     eine schematische Darstellung eines Querschnitts durch ein weiteres Ausführungsbeispiel eines Chips ;

Figur 5     einen Querschnitt durch ein Ausführungsbeispiel mit gerichteter Abstrahlung;

Figur 6     einen Querschnitt durch das erfindungsgemäße Ausführungsbeispiel, dessen Spiegelfläche unter dem aktiven Bereich die Photonen in seitliche Richtung lenkende Erhebungen aufweist;

Figur 7     ein Ausführungsbeispiel mit konkaver Spiegelfläche und

Figur 8     ein Bauelement mit nebeneinander angeordneten aktiven Bereichen, denen jeweils ein pyramidenstumpfförmiger Abschnitt eines Auskoppelfensters zugeordnet ist.

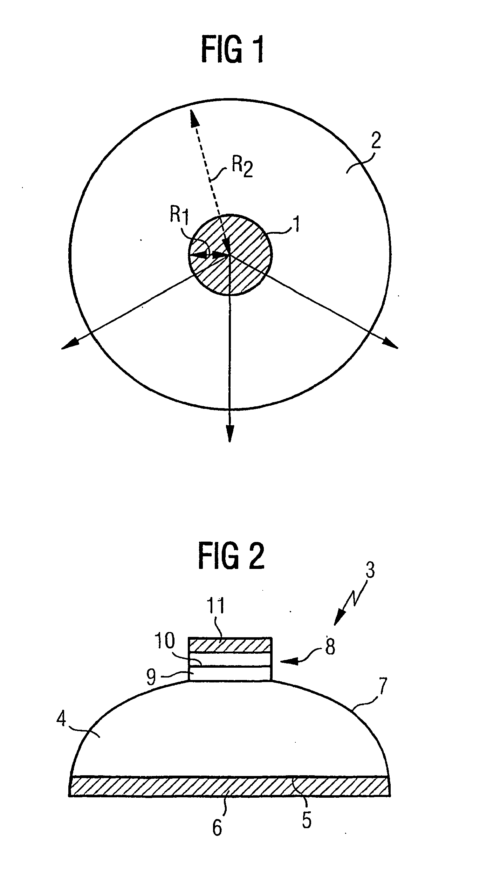

Das in Figur 1 dargestellte Element besitzt einen Querschnitt, der nach Weierstrass ideal gestaltet ist. Das Element weist einen inneren Licht erzeugenden Bereich 1 mit Radius $R_1$ auf. Der Licht erzeugende Bereich 1 ist von einer Hülle 2 mit Brechungsindex ni und Radius $R_2$ umgeben. Die Hülle 2 ist umgeben von einem Material mit Brechungsindex $n_A$ (z.B. Luft oder Kunststoff-Vergußmaterial). Damit das im Licht erzeugenden Bereich 1 erzeugte Licht vollständig aus der Hülle 2 auskoppeln kann, muß gelten: $R_1/R_2 < n_A/n_i$.

In Figur 2 ist ein Querschnitt durch einen Leuchtdioden(LED)-Chip 3 dargestellt, der ein kugelkalottenartiges Auskoppelfenster 4 aufweist, an dessen Grundfläche 5 eine Spiegelschicht 6 ausgebildet ist. Gegenüber der Spiegelschicht 6 ist auf dem Auskoppelfenster 4 ein Photonen emittierender aktiver Bereich 8 vorgesehen. Der aktive Bereich 8 umfaßt eine Schichtfolge 9 mit einer strahlungsemittierenden Zone 10, insbesondere einem strahlungsemittierenden pn-Übergang 10, und ist mit einer Kontaktschicht 11 abgedeckt. Der aktive Bereich 8 kann neben den Schichten der strahlungsemittierenden Zone 10 weitere, beispielsweise die kristalline oder elektrische Anpassung betreffende Schichten, und/oder auch sogenannte Abdeckschichten umfassen. Derartige Schichtenfolgen sind bekannt und werden von daher an dieser Stelle nicht näher erläutert. Auch die Spiegelschicht 6 kann als Kontaktschicht ausgebildet sein.

Bei Stromfluß durch das Auskoppelfenster 4 und den aktiven Bereich 8 werden in der strahlungserzeugenden Zone 10 durch Rekombination von Ladungsträgern Photonen erzeugt. Ein Teil dieser erzeugten Photonen wird zum Auskoppelfenster 4 hin emittiert, an der Grundfläche 5 reflektiert und zu einem großen Teil in Richtung auf die Auskoppelfläche 7 hin gelenkt. Falls sie dort unter einem Winkel auftreffen, der kleiner als der kritische Winkel (auch Grenzwinkel genannt) für die Totalreflexion ist, können die Photonen durch die Auskoppelfläche 7 hindurchtreten und das Auskoppelfenster 4 verlassen. Die Wahrscheinlichkeit, dass letzteres eintritt, ist mit einem solchen Chip im Vergleich zu herkömmlichen Chipgeometrien erhöht.

Besonders vorteilhaft ist, wenn die geometrischen Verhältnisse des Chips so gewählt werden, daß ein virtuelles Bild 12 des aktiven Bereichs 8 so bezüglich der Auskoppelfläche 7 zu liegen kommt, daß die Weierstrass'sche Bedingung für eine Lichtauskopplung ohne Totalreflexion erfüllt ist. Dies ist der Fall, wenn die Krümmungsradien $R_2$ der Auskoppelfläche 7 so gewählt werden, daß gilt: $2H - R_2 \, \dfrac{n_A}{n_i} \le R_2 \le 2H + R_2 \, \dfrac{n_A}{n_i}$, vorzugsweise $R_2 = 2H$, wobei H die Höhe des Chips 3 ist. Ferner muß für die halbe Ausdehnung $R_1$ des aktiven Bereichs 8, den Brechungsindex $n_1$ des aktiven Bereichs 8 und den Brechungsindex $n_2$ des Auskoppelfensters 4 gelten: $R_1/R_2 < n_A/n_i$. In diesem Fall kann ein Großteil der auf die Spiegelfläche 6 auftreffenden Photonen durch die Auskoppelfläche 7 auskoppeln. Ausgenommen davon sind im Wesentlichen nur diejenigen Photonen, die zwischen der Spiegelfläche 6 und dem aktiven Bereich 8 hin und her reflektiert werden oder im aktiven Bereich 8 wieder absorbiert werden.

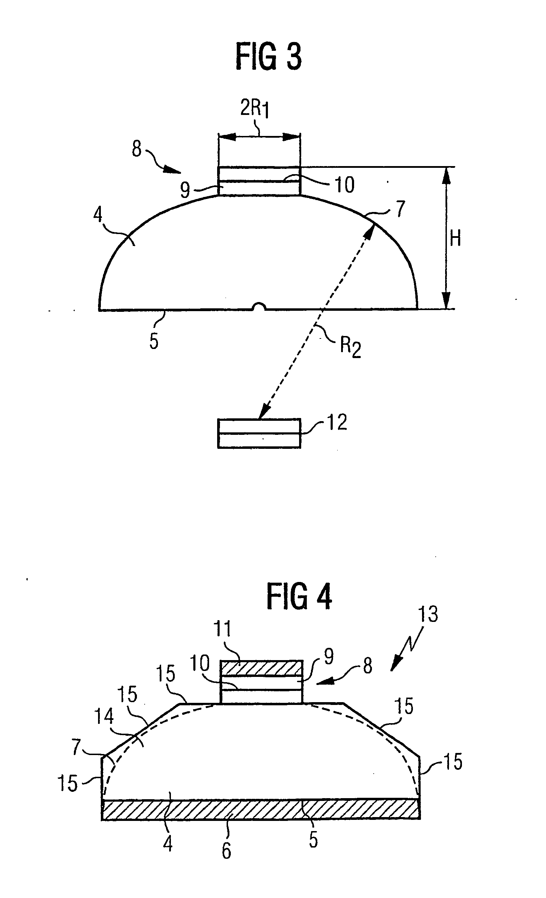

In Figur 4 ist ein abgewandelter Chip 13 dargestellt, dessen Auskoppelfenster 14 über eine Teildicke, ausgehend von der Grenzfläche zum aktiven Bereich 8 mittels schräg von der Chipachse weg verlaufenden Seitenflächen 15 pyramidenstumpfartig ausgebildet ist. Zusammen mit den übrigen Seitenflächen des Auskoppelfensters 14 bilden die schräg verlaufenden Seitenflächen 15 eine domartig gewölbte Auskoppelfläche, deren Einhüllende näherungsweise kugelkalottenartig ist. Letztere ist in Figur 4 durch die gestrichelte Linie eingezeichnet. Der in Figur 4 dargestellte Chip ist insofern von Vorteil, als er auf einfache Weise hergestellt werden kann und gleichzeitig der Idealform nach Weierstrass angenähert werden kann.

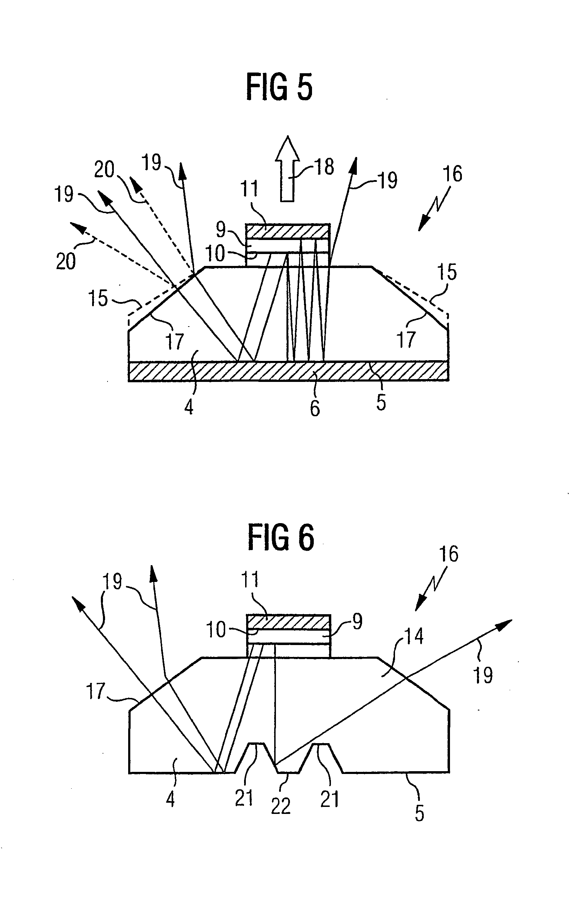

Abweichend von dem in Figur 4 dargestellten Chip 13 verlaufen bei dem in Figur 5 dargestellten Chip 16 die schräg verlaufenden Seitenflächen 17 in einem spitzeren Winkel zur Chipachse als die entsprechenden Seitenflächen 15 des Chips 13 von Figur 4. Die Seitenflächen 15 des Chips 13 sind in Figur 5 gestrichelt angedeutet. Durch den spitzeren Winkel der Seitenflächen 17 wird die vom Chip 16 ausgehende Strahlung in Richtung einer Abstrahlrichtung 18 konzentriert. Dies wird durch die mit durchgezogenen Linien in Figur 5 eingezeichneter Photonentrajektorien veranschaulicht, die gegenüber den gestrichelt eingezeichneten Photonentrajektorien 20 des Chips 13 aus Figur 4 stärker zur Abstrahlrichtung 18 hin ausgerichtet sind.

Anhand von Figur 5 wird auch deutlich, daß einige der Photonentrajektorien 19 mehrmals zwischen der Kontaktschicht 11 und der Spiegelschicht 6 hin und her verlaufen. Photonen, die solche Trajektorien aufweisen, werden zum Teil im aktiven Bereich 8 absorbiert und gehen verloren. Wie in Figur 6 angedeutet, wird gemäß der Erfindung durch Vorsehen von zur Chipachse schrägstehenden Flächen 30 an der vom aktiven Bereich 8 abgewandten Seite des Auskoppelfensters 14, die bevorzugt spiegelnd ausgebildet sind, dieses Problem zumindest gemindert. Die schräg stehenden Flächen 30 können die besagten Photonentrajektorien 19 in seitliche Richtung von der Chipachse weg lenken, so dass sie nicht mehr zum aktiven Bereich 8 hin, sondern zu einer Seitenfläche des Auskoppelfensters 14 hin reflektiert werden.

Solche schräg zur Chipachse stehenden Strahlungsumlenkflächen 30 können beispielsweise durch eine geeignete Strukturierung des Auskoppelfensters 14 mittels Ausnehmungen 21 und dazwischenliegenden Erhebungen 22 unter dem aktiven Bereich 8 in der Grundfläche 5 erzielt werden.

Die Ausnehmungen 21 können beispielsweise durch reaktives Ionen-Ätzen (RIE) oder durch Einsägen hergestellt sein.

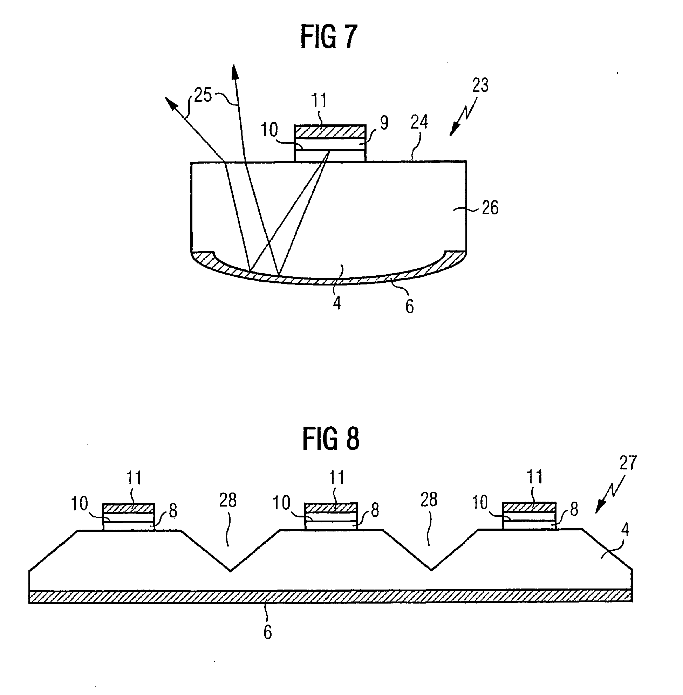

Bei dem in Figur 7 dargestellten Querschnitt durch ein weiteres Ausführungsbeispiel weist das Auskoppelfenster 26 an seiner vom aktiven Bereich 8 abgewandten Seite eine Spiegelschicht 6 mit der Form eines paraboloidartigen Hohlspiegels auf. Vorzugsweise befindet sich der Brennpunkt der Spiegelschicht 6 im aktiven Bereich 8. Durch Reflexion an der Spiegelfläche 6 werden die vom aktiven Bereich 8 ausgehenden Photonentrajektorien derart reflektiert, daß die Photonen unter einem Winkel der kleiner als der kritische Winkel für die Totalreflexion ist auf die Vorderseite 24 des Auskoppelfensters 26 treffen. Dies ist in Figur 7 anhand der Photonentrajektorien 25 veranschaulicht. Zuätzlich zu der paraboloidartigen Chiprückseite kann die Oberseite 24 des Auskoppelfensters 26 wie bei den Chips gemäß den Figuren 2, 4 und 5 ausgebildet sein.

Der Chipgeometrie gemäß Figur 7 hat den Vorteil, daß die Auskoppelfläche an der Vorderseite der Fensterschicht 26 und kleiner ist. Die Leuchtdichte ist vorteilhafterweise höher als beim Chip 3 gemäß Figur 2. Damit läßt sich das Licht mit nachgeordneten Optiken leichter abbilden.

Schließlich können, wie in Figur 8 dargestellt, mehrere Chips 3, 13 oder 23 nebeneinander angeordnet und zu einem einzigen Chip 27 verbunden sein. Die Seitenflächen 15 werden dabei durch Vertiefungen 28 im Auskoppelfenster 4 gebildet. Vorzugsweise werden die Vertiefungen 28 durch Profilsägen in das Auskoppelfenster 4 eingebracht.

Bei den in Figuren 1 bis 8 dargestellten Ausführungsbeispielen ist die Spiegelfläche 6 jeweils als Kontaktschicht ausgebildet. Es ist jedoch auch möglich, die Kontaktierung nicht ganzflächig vorzunehmen, sondern neben einer die Grundfläche 5 teilweise bedeckenden Kontaktierung eine Verspiegelung der restlichen Fläche vorzusehen. Eine die Grundfläche 5 teilweise bedeckende Kontaktierung kann beispielsweise netzartig oder streifenförmig ausgebildet sein. Zweckmäßigerweise sollte die entlang der Grundfläche 5 ausgebildete Kontaktschicht der oberen Kontaktschicht 11 genau gegenüberliegen, um die elektrischen Verluste klein zu halten.

Es ist auch möglich, anstelle einer Kontaktierung entlang der Grundfläche eine Kontaktierung zwischen dem aktiven Bereich 8 und dem Auskoppelfenster 4 bzw. 26 vorzusehen, die seitlich herausgeführt ist.

Bei den in den Figuren 2 bis 8 dargestellten Ausführungsbeispielen ist der aktive Bereich 8 jeweils auf einem linsenförmigen Auskoppelfenster 4 angeordnet. Es ist auch denkbar, bei den in Figuren 2 bis 6 dargestellten Ausführungsbeispielen das Auskoppelfenster 4 in der Gestalt einer Fresnel-Linse auszubilden. Ebenso kann bei dem in Figur 7 dargestellten Ausführungsbeispiel die Spiegelfläche 6 die Gestalt eines Fresnel-Spiegels aufweisen.

Die Kontakte können streifenförmig oder netzartig ausgebildet sein, wobei die Zwischenräume zwischen den Streifen bzw. Netzlinien vorzugsweise reflektierend ausgebildet sind.

Beispiel 1:

Die Auskoppeleffizienz wurde für den Chip 16 gemäß Figur 5 mit einer Grundfläche 5 von 400$\mu$m x 400$\mu$m und einem pn-Übergang 10 mit einer Fläche von 120$\mu$m x 120$\mu$m untersucht. Die Reflexion an der Spiegelfläche 6 war 90%, die Reflexion an der Kontaktschicht 11 war 80%. Die Seitenflächen 17 weisen einen Steigungswinkel von 60 Grad auf. Das Auskoppelfenster 4 wurde aus SiC gefertigt und der aktive Bereich 8 wurde auf der Basis von InGaN hergestellt. In diesem Fall konnten 42% der emittierten Photonen den Chip 16 verlassen.

Beispiel 2:

Bei einem weiteren Chip 16, der sich von dem Chip 16 aus Beispiel 1 nur durch einen Steigungswinkel der Seitenflächen 17 von 45 Grad unterscheidet, betrug die Auskoppeleffizienz 39%.

Vergleichsbeispiel 1:

Bei einem herkömmlichen Würfel-Chip mit der Grundfläche 400$\mu$m x 400$\mu$m, einer Rückseitenreflexion von 90%, einer Vorderseitenreflexion an einem Kontakt von 80% betrug die Auskoppeleffizienz 28%.

Vergleichsbeispiel 2:

Bei einem herkömmlichen Würfel-Chip mit der Grundfläche 400$\mu$m x 400$\mu$m und einer absorbierenden vorderseitigen Kontaktierung von 120$\mu$m x 120$\mu$m und einem weiteren vorderseitigen, transparenten Kontakt zur Stromaufweitung mit einer Transmission von 50% und mit einer Rückseitenreflexion von 90% betrug die Auskoppeleffizienz 25%.

Untersuchungen ergaben, dass bei dem in Figur 5 dargestellten Chip 16 eine Steigerung der Lichtausbeute gegenüber einem herkömmlichen Würfel-Chip um den Faktor 1,7 erzielt wird. Bei dem in Figuren 1 bis 4 dargestellten Ausführungsbeispiel ist die Steigerung der Lichtausbeute noch deutlich höher.

Die Steigerung der Lichtausbeute ist insbesondere bei UV-Licht emittierenden Chips wesentlich, da die zum Vergießen der Chips verwendeten Materialien im allgemein UV-Licht absorbieren und daher nicht verwendet werden können. Die hier vorgestellten Chips 3,13,16 und 23 weisen jedoch eine so hohe Auskoppeleffizienz auf, daß auf einen Verguß verzichtet werden kann.

**Patentansprüche**

1. Chip für die Optoelektronik mit einem Photonen emittierenden aktiven Bereich (8) und einem mindestens eine Auskoppelfläche (7, 15, 17) aufweisenden Auskoppelfenster (4), wobei

- der aktive Bereich (8) bezogen auf eine Hauptabstrahlrichtung (18) des Chips dem Auskoppelfenster (4) nachgeordnet ist,
- auf der dem aktiven Bereich (8) gegenüberliegenden Seite (5) des Auskoppelfensters (4) eine Spiegelfläche (6) ausgebildet ist,
- die Auskoppelflächen (7, 15, 17) seitlich über die Seitenflächen des aktiven Bereichs (8) hinausragen,
- das Auskoppelfenster (4) eine domartige Form aufweist, wobei sich das Auskoppelfenster (4) zum aktiven Bereich (8) hin verjüngt,
- der aktive Bereich (8) eine senkrecht zu einer durch den aktiven Bereich verlaufenden Chipachse liegende Querschnittsfläche aufweist;
**dadurch gekennzeichnet, dass**
- die Spiegelfläche (6) größer ist als die Querschnittsfläche des aktiven Bereichs (8) und aus einer Metallisierungsschicht gebildet ist; und

- die Spiegelfläche (6) unter dem aktiven Bereich (8) die Photonen in seitliche Richtung lenkende Erhebungen (22) aufweist.

2. Chip nach Anspruch 1,
der als LED-Chip ausgeführt ist.

3. Chip nach Anspruch 1 oder 2,
**dadurch gekennzeichnet,**
**daß** der aktive Bereich (8) eine auf dem Auskoppelfenster (4) ausgebildete Schichtenfolge (9) ist.

4. Chip nach einem der Ansprüche 1 bis 3,
**dadurch gekennzeichnet,**
**daß** das Auskoppelfenster (4) eine kugelkalottenartige Form aufweist.

5. Chip nach einem der Ansprüche 1 bis 3,
**dadurch gekennzeichnet,**
**daß** das Auskoppelfenster (4) wenigstens abschnittsweise pyramidenstumpfförmig ausgebildet ist.

6. Chip nach Anspruch 5,
**dadurch gekennzeichnet,**
**daß** das wenigstens abschnittsweise pyramidenstumpfförmig ausgebildete Auskoppelfenster (4) ein Kugelsegment umhüllt.

7. Chip nach Anspruch 5,
**dadurch gekennzeichnet,**
**daß** das wenigstens abschnittsweise pyramidenstumpfförmige Auskoppelfenster (4) ein Rotationsellipsoid mit durch den aktiven Bereich (8) verlaufender Längsachse umhüllt.

8. Chip nach einem der Ansprüche 1 bis 7,
**dadurch gekennzeichnet,**
**daß** die Spiegelfläche (6) gekrümmt ist.

9. Chip nach Anspruch 8,
**dadurch gekennzeichnet,**
**daß** die Spiegelfläche (6) gesehen vom aktiven Bereich (8) konkav ausgebildet ist.

10. Chip nach Anspruch 9,
**dadurch gekennzeichnet,**
**daß** die Spiegelfläche (6) als Paraboloid ausgebildet ist.

11. Chip nach Anspruch 10,
**dadurch gekennzeichnet,**
**daß** die Spiegelfläche (6) als Fresnel-Spiegel ausgebildet ist.

12. Chip nach einem der Ansprüche 1 bis 11,
**dadurch gekennzeichnet,**
**daß** die Spiegelfläche (6) als Kontaktfläche dient.

13. Chip nach einem der Ansprüche 1 bis 12,
**dadurch gekennzeichnet,**
**daß** zwischen aktivem Bereich (8) und Auskoppelfenster (4) eine Kontaktschicht ausgebildet ist.

14. Chip nach einem der vorangehenden Ansprüche,
**dadurch gekennzeichnet,**
**daß** das Material des Auskoppelfensters einen größeren Brechungsindex aufweist als das Material des aktiven Bereichs.

**15.** Chip nach einem der vorangehenden Ansprüche,
**dadurch gekennzeichnet,**
**daß** ein Nitrid-basierter aktiver Bereich vorgesehen ist und das Auskoppelfenster SiC oder SiC-basiertes Material aufweist.

**16.** Chip nach Anspruch 15,
**dadurch gekennzeichnet,**
**daß** eine strahlungsemittierende Schicht des aktiven Bereichs GaN, InGaN, AlGaN und/oder InGaAlN aufweist.

**17.** Chip nach einem der vorangehenden Ansprüche,
**dadurch gekennzeichnet,**
**daß** der aktive Bereich auf dem Auskoppelfenster aufgewachsen ist.


**Claims**

**1.** Chip for optoelectronics having a photon-emitting active region (8) and a coupling-out window (4) having at least one coupling-out area (7, 15, 17),
wherein

- the active region (8) is arranged downstream of the coupling-out window (4) relative to a main radiation direction (18) of the chip,
- a mirror area (6) is formed on that side (5) of the coupling-out window (4) which is opposite to the active region (8),
- the coupling-out areas (7, 15, 17) project laterally beyond the side areas of the active region (8),
- the coupling-out window (4) has a dome-like form, the coupling-out window (4) tapering toward the active region (8),
- the active region (8) has a cross-sectional area perpendicular to a chip axis running through the active region;
**characterized in that**
- the mirror area (6) is larger than the cross-sectional area of the active region (8) and is formed from a metallization layer; and
- the mirror area (6) has, below the active region (8), elevations (22) which direct the photons in a lateral direction.

**2.** Chip according to Claim 1,
which is realized as an LED chip.

**3.** Chip according to Claim 1 or 2,
**characterized in that**
the active region (8) is a layer sequence (9) formed on the coupling-out window (4).

**4.** Chip according to one of Claims 1 to 3,
**characterized in that**
the coupling-out window (4) has a spherical-cap-like form.

**5.** Chip according to one of Claims 1 to 3,
**characterized in that**
the coupling-out window (4) is formed in the shape of a truncated pyramid at least in sections.

**6.** Chip according to Claim 5,
**characterized in that**
the coupling-out window (4) formed in the shape of a truncated pyramid at least in sections envelopes a spherical segment.

**7.** Chip according to Claim 5,
**characterized in that**
the coupling-out window (4) which is in the shape of a truncated pyramid at least in sections envelopes a rotational ellipsoid with a longitudinal axis running through the active region (8).

**8.** Chip according to one of Claims 1 to 7,

**characterized in that**
the mirror area (6) is curved.

9. Chip according to Claim 8,
   **characterized in that**
   the mirror area (6) is formed in concave fashion as seen from the active region (8).

10. Chip according to Claim 9,
    **characterized in that**
    the mirror area (6) is formed as a paraboloid.

11. Chip according to Claim 10,
    **characterized in that**
    the mirror area (6) is formed as a Fresnel mirror.

12. Chip according to one of Claims 1 to 11,
    **characterized in that**
    the mirror area (6) serves as a contact area.

13. Chip according to one of Claims 1 to 12,
    **characterized in that**
    a contact layer is formed between active region (8) and coupling-out window (4).

14. Chip according to one of the preceding claims,
    **characterized in that**
    the material of the coupling-out window has a larger refractive index than the material of the active region.

15. Chip according to one of the preceding claims,
    **characterized in that**
    a nitride-based active region is provided and the coupling-out window has SiC or SiC-based material.

16. Chip according to Claim 15,
    **characterized in that**
    a radiation-emitting layer of the active region has GaN, InGaN, AlGaN and/or InGaAlN.

17. Chip according to one of the preceding claims,
    **characterized in that**
    the active region is grown on the coupling-out window.

**Revendications**

1. Puce pour optoélectronique, la puce présentant une partie active (8) émettant des photons et au moins une fenêtre d'émission (4) qui présente une surface d'émission (7, 15, 17),
   la partie active (8) étant disposée en aval de la fenêtre d'émission (4) dans la direction principale de rayonnement (18) de la puce,
   une surface réfléchissante (6) étant formée sur le côté (5) de la fenêtre d'émission (4) située face à la partie active (8),
   les surfaces d'émission (7, 15, 17) débordant latéralement au-delà des surfaces latérales de la partie active (8),
   la fenêtre d'émission (4) présentant la forme d'un dôme, la fenêtre d'émission (4) se rétrécissant en direction de la partie active (8),
   la partie active (8) présentant une section transversale perpendiculaire à l'axe de la puce qui traverse la partie active,
   **caractérisée en ce que**
   la surface réfléchissante (6) est plus grande que la surface de la section transversale de la partie active (8) et est formée d'une couche métallisée et
   **en ce que** la surface réfléchissante (6) présente en dessous de la partie active (8) des rehaussements (22) qui dévient les photons en direction latérale.

2. Puce selon la revendication 1, configurée comme puce LED.

3. Puce selon les revendications 1 ou 2, **caractérisée en ce que** la partie active (8) est formée d'une succession (9) de couches formée sur la fenêtre d'émission (4) .

4. Puce selon l'une des revendications 1 à 3, **caractérisée en ce que** la fenêtre d'émission (4) présente la forme d'une calotte sphérique.

5. Puce selon l'une des revendications 1 à 3, **caractérisée en ce qu'**au moins certaines parties de la fenêtre d'émission (4) présentent la forme d'un tronc de pyramide.

6. Puce selon la revendication 5, **caractérisée en ce que** la fenêtre d'émission (4) dont au moins certaines parties sont configurées en forme de tronc de pyramide englobe un segment sphérique.

7. Puce selon la revendication 5, **caractérisée en ce que** la fenêtre d'émission (4) dont au moins certaines parties sont configurées en forme de tronc de pyramide englobe un ellipsoïde de rotation dont l'axe longitudinal traverse la partie active (8).

8. Puce selon l'une des revendications 1 à 7, **caractérisée en ce que** la surface réfléchissante (6) est courbée.

9. Puce selon la revendication 8, **caractérisée en ce que** la surface réfléchissante (6) est concave par rapport à la partie active (8).

10. Puce selon la revendication 9, **caractérisée en ce que** la surface réfléchissante (6) est configurée en paraboloïde.

11. Puce selon la revendication 10, **caractérisée en ce que** la surface réfléchissante (6) est configurée en miroir de Fresnel.

12. Puce selon l'une des revendications 1 à 11, **caractérisée en ce que** la surface réfléchissante (6) sert de surface de contact.

13. Puce selon l'une des revendications 1 à 12, **caractérisée en ce qu'**une couche de contact est formée entre la partie active (8) et la fenêtre d'émission (4) .

14. Puce selon l'une des revendications précédentes, **caractérisée en ce que** le matériau de la fenêtre d'émission présente un indice de réfraction plus grand que celui du matériau de la partie active.

15. Puce selon l'une des revendications précédentes, **caractérisée en ce qu'**elle présente une partie active à base de nitrure et **en ce que** la fenêtre d'émission présente du SiC ou un matériau à base de SiC.

16. Puce selon la revendication 15, **caractérisée en ce qu'**une couche d'émission de rayonnement de la partie active présente du GaN, de l'InGaN, de l'AlGaN et/ou de l'InGaAlN.

17. Puce selon l'une des revendications précédentes, **caractérisée en ce que** la partie active est formée par croissance sur la fenêtre d'émission.

## FIG 1

## FIG 2

# FIG 3

# FIG 4

## FIG 5

## FIG 6

# FIG 7

# FIG 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5087949 A
- EP 0562880 A1
- US 6025251 A
- EP 0415640 A2